# EUROPÄISCHE PATENTSCHRIFT

(11) **EP 1 148 602 B1**
(45) Veröffentlichungstag und Bekanntmachung des Hinweises auf die Patenterteilung: **26.11.2003**
(21) Anmeldenummer: 01104332.0
(22) Anmeldetag: 23.02.2001
(51) Int. Cl.: H01T 4/08, H05K 1/02

(54) **Überspannungsschutzeinrichtung**
Overvoltage arrester device
Dispositif limiteur de surtensions

(30) Priorität: 20.04.2000 DE 10019885; 22.08.2000 DE 10041290
(43) Veröffentlichungstag der Anmeldung: 24.10.2001
(73) Patentinhaber: Siemens Aktiengesellschaft, 80333 München (DE)
(72) Erfinder: Berberich, Reinhold, 60439 Frankfurt (DE)

(56) Entgegenhaltungen:
- DE-A- 3 226 569
- DE-A- 19 857 478
- GB-A- 2 122 807
- PATENT ABSTRACTS OF JAPAN vol. 1998, no. 11, 30. September 1998 (1998-09-30) & JP 10 154854 A (NEC HOME ELECTRON LTD), 9. Juni 1998 (1998-06-09)

## Beschreibung

Die Erfindung betrifft eine Überspannungsschutzeinrichtung gemäß dem Oberbegriff des Patentanspruchs 1.

Um elektronische Geräte vor Hochspannung zu schützen, ist es üblich, spannungsklemmende Bauelemente wie bspw. Varistoren oder Zener-Dioden einzusetzen. Derartige Überspannungsschutzelemente müssen innerhalb des Gehäuses so ausgeführt werden, dass die die Funktion des Gerätes ausführenden elektronischen Bauteile in ihrer Arbeitsweise nicht beeinträchtigt werden.

Aus der DE 32 26 569 A1 die als nächstliegender Stand der Technik angesehen wird, ist eine Anordnung von Funkenstrecken bekannt, gemäß Oberbegriff des Anspruchs 1, wobei ein Gehäuseteil eine Isolierstoffgrundplatte trägt, welche kreisförmige Bunde aufweist. Auf der Grundplatte ausgebildete Elektroden sind zu den Bunden und den diese umgebenden kreisförmigen Durchbrüchen einer Erdplatte konzentrisch angeordnet, wodurch sich horizontale konzentrische Gleitüberschlagstellen bilden.

Gemäß einem Überschlagsschutzgerät gemäß GB 2 122 807 ist eine Steckeinrichtung mit einer Isolierplatte versehen, welche einen elektrisch leitenden Überzug aufweist. Elektrische Leiter sind durch die Isolierplatte hindurchgeführt, wobei die Funkenstrecke als Abstand zwischen dem elektrischen Leiter und dem elektrischen Überzug der Isolierplatte ausgebildet ist. Auch hierbei handelt es sich um einen horizontalen Überspannungsschutz.

Der Erfindung liegt die Aufgabe zugrunde, einen vertikalen Überspannungsschutz anzugeben, bei welchem auf zusätzliche Abschirmmaßnahmen gegenüber der Elektronik verzichtet werden kann.

Erfindungsgemäß wird die Aufgabe durch die Merkmale des Patentanspruchs 1 gelöst.

Die Erfindung hat den Vorteil, dass die Hochspannung bereits an der Gehäuseaußenseite abgeführt wird und Abschirmmaßnahmen für die innen liegenden Bauteile nicht notwendig sind. Durch die Dicke der Isolationsschicht ist der Abstand der Funkenstrecke definiert und hoch genau sowie ohne erhöhten Aufwand herstellbar.

Vorteilhafterweise bildet die Schutzplatine mit dem Steckelement eine weitere Funkenstrecke.

In einer Weiterbildung der Erfindung weist die Schutzplatine eine elektrisch leitende Struktur zur Bildung der weiteren Funkenstrecke auf. Solche geätzten Strukturen sind einfach herstellbar und führen zu einem Funkenüberschlag auf die Platinenoberfläche in horizontaler Richtung.

Vorteilhafterweise ist die elektrisch leitende Struktur auf der Schutzplatine in Form einer Leiterbahn ausgebildet, wobei eine lötstopplackfreie Zone der Leiterbahn in der Umgebung einer, das Steckelement aufnehmenden Öffnung angeordnet ist. Durch die Verwendung üblicher Herstellungsverfahren für Leiterplatten kann die lötstoplackfreie Zone einfach in die Lötstopmaske mit eingearbeitet werden. Die weitere Funkenstrecke wird dabei durch an sich vorhandene Bauteile wie Steckelement und Leiterbahn realisiert. Zusätzliche spannungsklemmende Bauelemente werden nicht benötigt.

Die weitere Funkenstrecke wird zuverlässig dadurch realisiert, dass die lötstoplackfreie Zone in dem die Öffnung umschließenden Lötauge ausgebildet ist.

In einer Weiterbildung der Erfindung ist die elektrisch leitende Struktur als lötstopplackfreie Ausnehmung oder durchgehende Öffnung der Schutzplatine ausgebildet, welche vorteilhafterweise in der Nähe des zu schützenden Steckerpins angeordnet ist.

Die Herstellung lässt sich weiter vereinfachen, wenn der Platinenrand von einer durchgehenden Öffnung der Schutzplatine gebildet ist. Diese kann überall dort, wo zu schützendes und Bezugspotential übereinander liegen z. B. durch einfaches Einbringen einer Bohrung eingebracht werden.

Vorteilhafterweise trägt die Schutzplatine eine Entstöreinrichtung zur Verbesserung der elektromagnetischen Empfindlichkeit des elektronischen Gerätes. Dadurch sind sowohl der Überspannungsschutz als auch Maßnahmen zur Erhöhung der elektromagnetischen Verträglichkeit am Gerätestecker integriert.

In einer Ausgestaltung ist die Entstöreinrichtung ein Varistor.

Alternativ dazu ist die Entstöreinrichtung ein Kondensator, der außerhalb des Gehäuses des elektronischen Gerätes angeordnet ist, und elektrisch einerseits mit dem Steckelement der Steckeinrichtung und andererseits mit dem Potential des elektrisch leitend ausgebildeten Gehäuses verbunden ist.

Die Erfindung hat den Vorteil, dass die Entstörung bereits auf der Außenseite des elektronischen Gerätes realisiert ist und Störstrahlungen gar nicht erst in das Gehäuseinnere gelangen. Bei der Montage des elektronischen Gerätes entsteht durch einfachen Einsatz des Steckers in das Gehäuse ein Entstörfilter. Zusätzliche Verarbeitungsmaßnahmen entfallen.

Vorteilhafterweise ist eine erste Kondensatorplatte des Kondensators in/oder an der Steckeinrichtung angeordnet, wodurch auf Leitungen zum Kondensator verzichtet werden kann.

Vorzugsweise ist die erste Kondensatorplatte aus dem Steckelement selbst ausgeformt. Sie kann z. B. durch Stauchung des Steckerstiftes einfach realisiert werden. Die Herstellung des Steckers wird somit weiter vereinfacht.

Alternativ ist die erste Kondensatorplatte von der auf der Schutzplatine angeordneten und als Leiterfläche ausgebildeten Leiterbahn gebildet, wobei die Leiterfläche neben dem, ein erstes Potential führenden Steckelement angeordnet und mit diesem elektrisch verbunden ist. Das elektrischleitend ausgebildete und ein zweites Potential führende Gehäuse des elektronischen Gerätes dient als zweite Kondensatorplatte. Die Verbindung von isolationsfreien Steckerstift und erster Kondensatorfläche erfolgt einfach durch Form- und/oder Kraftschluss. Somit entsteht eine für die Massenfertigung besonders gut handhabbare Einrichtung.

Zur Realisierung der zweiten Kondensatorplatte ist eine zweite, auf der Schutzplatine angeordnete Leiterfläche mit dem Gehäuse elektrisch verbunden.

Eine in der Massenfertigung besonders gut handhabbare Entstöreinrichtung besteht darin, dass die elektrische Verbindung zwischen der zweiten Leiterfläche der Schutzplatine und dem Gehäuse durch mindestens ein die Schutzplatine und/oder die Steckeinrichtung am Gehäuse haltendes Befestigungsmittel erfolgt. Das Gehäusepotential wird dabei über an sich vorhandene Schraub-, Niet- oder Preßverbindungen an mindestens einem Punkt realisiert.

Bei einer Ausgestaltung der Erfindung ist eine Isolierung zwischen der zweiten, auf der Oberfläche der Schutzplatine ausgebildeten Leiterfläche und der Außenseite des Gehäuses angeordnet. Alternativ kann die auf der Oberfläche der Schutzplatine angeordnete Leiterfläche direkt auf dem Gehäuse aufliegen.

In einer Weiterbildung der Erfindung ist die das Steckelement umschließende Leiterfläche derart auf der Schutzplatine angeordnet, dass sie auf der dem Gehäuse zugewandten Seite der Steckeinrichtung aufsetzbar und kontaktierbar ist. Somit kann ein kommerziell erhältlicher Stecker mit der erfindungsgemäßen Schutzplatine versehen werden. Dabei ist vorteilhafterweise für jedes Steckelement der Steckeinrichtung eine erste Kondensatorplatte vorgesehen, welche elektrisch gegeneinander isoliert sind.

Die Erfindung lässt zahlreiche Ausführungsformen zu. Eine davon soll anhand der in der Zeichnung dargestellten Figuren näher erläutert werden.

Es zeigt:
- Figur 1:: Schnitt durch ein Steuergerät.
- Figur 2:: erste Ausführungsform einer Kondensatoranordnung auf der Entstörplatine
- Figur 3:: zweite Ausführungsform einer Kondensatoranordnung auf der Entstörplatine
- Figur 4:: erste Ausführungsform der erfindungsgemäßen Entstörplatine
- Figur 5:: zweite Ausführungsform der erfindungsgemäßen Entstörplatine
- Figur 6:: Kondensatorfläche mit kupferfreien Stellen

Gleiche Merkmale sind mit gleichen Bezugszeichen gekennzeichnet.

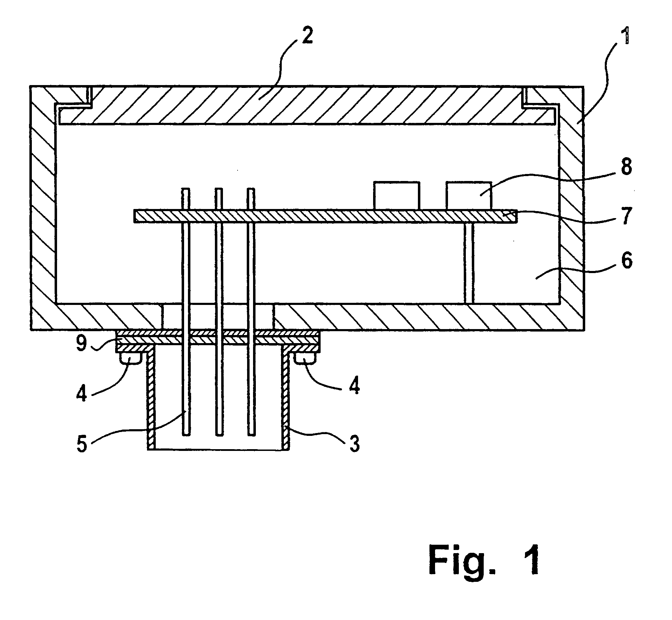

In Figur 1 ist ein elektrisches Gerät dargestellt, wie es üblicherweise in Kraftfahrzeugen Anwendung findet. Dabei kann es sich um ein Steuergerät eines Kraftfahrzeuges handeln, welches eine signalverarbeitende Elektronik aufweist, die bekanntlicherweise sehr störanfällig gegenüber hohen Frequenzen ist. Es ist aber auch vorstellbar, dass das elektronische Gerät eine Sensoreinrichtung darstellt, welche neben einem eigentlichen Sensor eine Signalaufbereitungsschaltung und/oder eine Signalauswerteschaltung aufweist, die auf einer oder mehreren Leiterplatten angeordnet sind.

Das elektronische Gerät besitzt ein aus Aluminium bestehendes, becherförmiges Gehäuseteil 1, welches mit einer Abdeckung 2 verschlossen ist. Das becherförmige Gehäuseteil 1 weist einen Steckerkörper 3 auf, welcher am Gehäuseteil 1 mittels Schrauben oder Nieten 4 außenseitig befestigt ist. Die Steckerpins 5 des Steckerkörpers 3 ragen sowohl in den Steckerkörper 3 als auch in das Gehäuseinnere 6. Der Stecker 3 verbindet über die Steckerpins 5 die Schaltungen des Gerätes mit anderen elektronischen Einrichtungen im Kraftfahrzeug.

Im Gehäuseinneren 6 ist mindestens eine Leiterplatte 7 angeordnet, welche Bauelemente 8 trägt, die die elektronischen Schaltungen realisieren. Die in das Gehäuseinnere 6 hineinragenden Steckerpins 5 sind elektrisch zur Zuführung von Signalen und elektrischer Leistung mit dem auf der Leiterplatte 7 befindlichen Bauelementen 8 verbunden.

Zwischen dem Stecker 3 und der Außenseite des Gehäuseteiles 1 ist eine Entstörplatine 9 eingelegt, welche gemeinsam mit dem Stecker 3 am Gehäuseteil 1 befestigt ist.

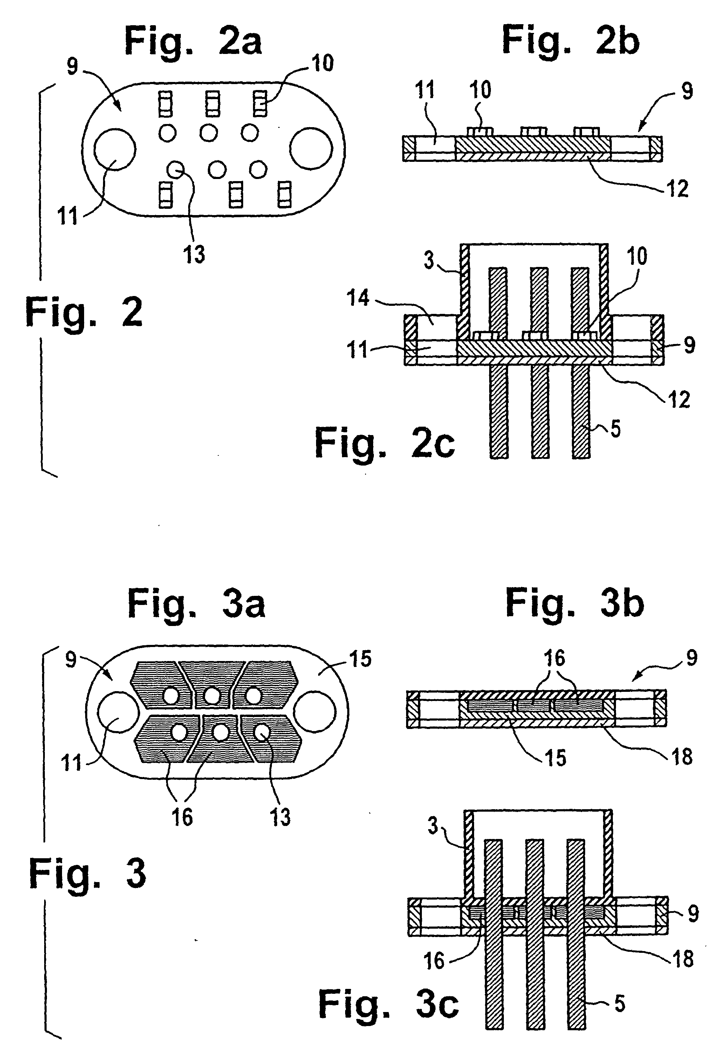

Verschiedene Ausführungsformen der Entstörplatine 9 sind in den Figuren 2 bis 5 näher erläutert.

Figur 2 zeigt eine Entstörplatine 9 mit Öffnungen 13 für die Steckerpins 5. Neben diesen Öffnungen 13 ist für jeden Steckerpin 5 ein diskreter Kondensator 10 vorgesehen, der mittels einer auf der Platine 9 angeordneten Verdrahtung so verschaltet ist, dass jeder Kondensator 10 einerseits mit dem Steckerpinpotential und andererseits mit dem Potential des Gehäuses 1 verbunden ist. Das Gehäusepotential ist dabei üblicherweise auf Masse gelegt.

Die vorgefertigte Platine 9 wird über die Steckerpins 5 geschoben, wobei eine umlaufende Steckerdichtung 12 die Platine 9 an deren Rand umschließt und gleichzeitig abdichtet. Mit Schrauben 4, welche in die Öffnungen 11 der Platine 9 und die Öffnungen 14 des Steckerkörpers 3 eingreifen, wird die Platine 9 an der Außenhaut des Gehäuseteils 1 befestigt. Die Befestigung erfolgt dabei so, dass die Dichtung 12 auf dem Gehäuseteil 1 aufliegt. Die Schrauben 4 verbinden die Kondensatoren 10 gleichzeitig elektrisch mit dem Gehäusepotential.

Eine andere Ausführungsform, bei welcher Kapazitäten in der Platine 9 integriert sind, ist in Figur 3 dargestellt. Die Platine 9 ist als Filmleiterplatte ausgebildet und weist eine strukturierte Leiterschicht 15 auf. Die Struktur entspricht einzelnen, gegeneinander isolierten Kondensatorflächen 16. Für jeden Steckerpin 5 ist dabei eine Kondensatorfläche 16 vorgesehen, welche die Öffnung 13 des jeweiligen Steckerpins 5 umschließt. Diese Öffnungen 13 sind metallisiert , wobei jede Kondensatorfläche 16 an der Grenzfläche mit der metallisierten Öffnung 13 verbunden ist, wodurch eine elektrische Verbindung entsteht. Nach Einfügen der Steckerpins 5 liegen die Kondensatorflächen 16 auf Steckerpotential. Bei dieser Ausführung sind als elektrische Verbindungsmechanismen Einpressvorgänge für die Kontaktierung von besonderem Vorteil.

Die Filmleiterplatte 9 weist auf der dem Gehäuse zugewandten Oberfläche eine weitere Leitschicht 18 auf, welche direkt nach Montage des Steckers 3 auf dem Gehäuse 1 aufliegt. Sie nimmt somit das Gehäusepotential an. Diese unstrukturierte Leitfläche 18 ist vorzugsweise als Leitkleber ausgebildet, um die Entstörplatine 9 am Gehäuse zu befestigen.

Alternativ kann die Entstörplatine 9, deren Kondensator durch die strukturierte Leiterschicht 18 von Gehäuseteil 1 isoliert sind, auch ohne Leitfläche 18 montiert werden, wenn die zweite Kondensatorplatte 18 vom Gehäuse 1 selbst gebildet wird.

Auf Grund dieser Ausgestaltung wirkt jeder Steckerpin 5 selbst als Kondensatorplatte und bildet mit dem mit Masse verbundenen Gehäuseteil 1 einen Entstörkondensator.

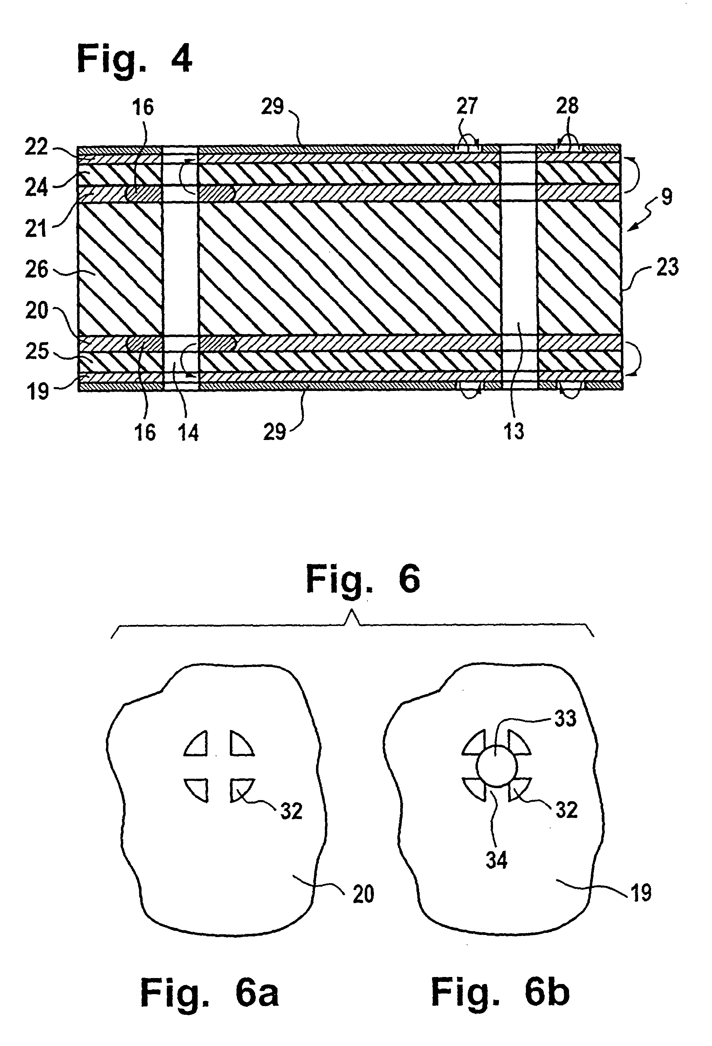

Eine Ausführungsform gemäß der Erfindung ist in Figur 4 dargestellt. Gemäß dieser Ausführung ist die Platine 9 mit vier Kupferlagen 19, 20, 21, 22 versehen. Je eine Kupferlage 19 und 22 ist auf je einer der beiden Außenseiten der Platine 9 angeordnet. Innerhalb der Platine 9 befinden sich, voneinander isoliert, zwei weitere Kupferlagen 20, 21, welche die Kondensatorflächen 16 bilden, wie sie im Zusammenhang mit Figur 3 beschrieben wurden.

Die beiden äußeren Kupferlagen 19, 22 sind über die Befestigungselemente 4 mit dem Gehäusepotential verbunden und gegen das Potential, welches die Steckerpin 5 führen, elektrisch isoliert. Die Kondensatorflächen 16 sind in der ebenfalls beschriebenen Weise elektrisch mit den Steckerpins 5 verbunden. Somit werden pro Steckerpin 2 Kondensatorflächenpaare realisiert. Werden noch mehr Kondensatorflächenpaare benötigt, so lassen sich diese einfach durch weiteren abwechselnden Einbau von Kupferlagen 20, 21, die die strukturierten Kondensatorflächen 16 bilden und unstrukturierte, ganzflächig ausgebildeten Kupferlagen 19, 22, welche auf Gehäusepotential liegen, erreichen.

Neben der erläuterten Ausführung können die Kondensatorflächen 16 auch mit Hilfe von Stanzteilen oder Kaptonfolien gebildet werden, welche in ein isolierendes Material eingebettet sind. Je nach dem zur Umhüllung der Kondensatorplatten verwendetem Material bzw. Materialkombination kann dieses gleichzeitig Dichtungsaufgaben wahrnehmen.

Diese erfindungsgemäßen Kondensatorflächen bilden gegenüber dem Außengehäuse Kapazitäten im Bereich bis zu 50 pF.

Zur Realisierung des Überspannungsschutzes sind die nicht isolierten Enden der Kupferlagen 19, 20, 21, 22 bis zum Rand 23 der Platine 9 geführt. Alternativ können die Kupferlagen 19, 20, 21, 22 auch unisoliert in einer Öffnung 14 der Platine 9 enden, die z. B. durch Einbringen einer Bohrung erstellt werden kann.

Die bei der Platinenherstellung erzeugten kupferfreien Stellen 32 sorgen dafür, dass nach Einbringen der Bohrung 33 Leiterspitzen 34 entstehen, die den Funkenüberschlag begünstigen. (Figur 6).

Zwischen den Kupferlagen 19 und 20 ist eine Isolierschicht 25 und zwischen den Kupferlagen 21 und 22 eine Isolierschicht 24 angeordnet. Die Kupferlagen 21 und 20 sind durch eine dritte Isolierschicht 26 getrennt, welche eine Dicke aufweist, die aus Stabilitätsgründen ein Mehrfaches der Dicke der jeweiligen Isolationsschicht 24 oder 25 beträgt, da sie als Trägerschicht dient. Durch die Dicke der Isolationsschichten 24, 25 ist der Luftspalt zwischen den Kupferlagen 19 und 20 bzw. 21 und 22 sehr gering, so das bei Überspannung ein Funkenüberschlag zwischen diesen Kupferlagen erfolgt.

Auf der Oberfläche der Kupferlagen 19 und 22 ist eine Lötstopplackstruktur 29 aufgebracht, welche die die Steckelemente 5 aufnehmende Öffnung 13 und die sich daran anschließende Leiterbahn bedeckt.

Die Lötstopplackstruktur 29 ist an vorgesehenen Stellen unterbrochen, so dass die Kupferlagen 19, 22 an diesen Stellen frei liegen. So bilden weitere, elektrisch leitend und nicht isoliert ausgebildete Bohrungen 27, 28 an der Oberfläche der Platine 9 eine horizontale Funkenüberschlagsstrecke.

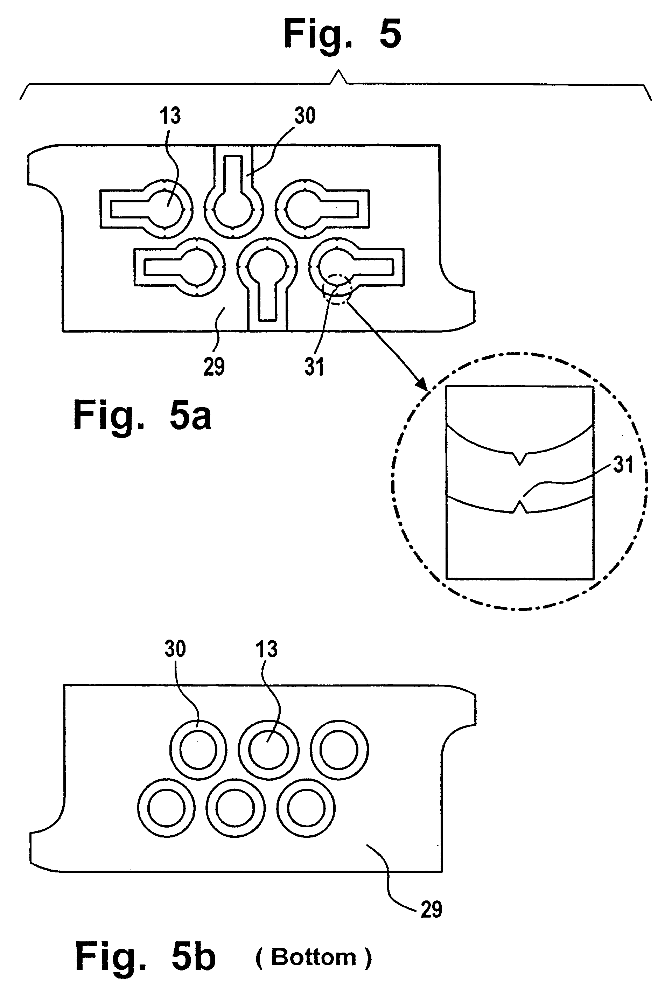

Darüber hinaus besteht die in Figur 5 dargestellte Möglichkeit, die die Öffnung 13 umschließenden Lötaugen 30 in ihrer Breite zu verengen, um einen Funkenüberschlag zu ermöglichen.

Dazu ist mit Hilfe einer Lötstopmaske die Lötstoplackstruktur 29 aufgebracht, bei welcher im Bereich des Lötstopauges 30 in den Lötstoplack Einschnürungen 31 zum Freilegen der darunter liegenden Kupferlage 19 bzw. 22 in gleichmäßigen Abständen vorgesehen sind. Im vorliegenden Fall sind drei Einschnürungen 31 in 90 °C Abständen vorgesehen. Die Einschnürung 31 ist vergrößert dargestellt. Durch die Nähe der Einschnürung 31 zum Steckelement 3 werden Überschlagstellen für einen potentiellen Funkenüberschlag hergestellt.

Auf der Rückseite (Bottom) der Platine 9 sind die Lötstopaugen 30 hier in herkömmlicher Weise kreisförmig realisiert.

## Patentansprüche

1. Überspannungsschutzeinrichtung für ein elektronisches Gerät mit einer, mindestens ein Steckelement (3) aufweisenden Steckeinrichtung, die zur Befestigung an einem Gehäuse des elektronisches Gerätes ausgebildet ist, wobei an dem Steckelement (3) eine Schutzplatine (9) angeordnet ist, welche eine Funkenstrecke zur Ableitung von Überspannungen aufweist, **dadurch gekennzeichnet, dass** die Schutzplatine (9) mindestens zwei übereinanderliegende, unterschiedliches Potential führende Leiterbahnen (19, 20; 21, 22) aufweist, welche bis zu einem Platinenrand (23) geführt sind, wobei die Stärke einer zwischen den beiden Leiterbahnen (19, 20; 21, 22) angeordneten Isolationsschicht (24, 25) so gewählt ist, dass die Funkenstrecke durch die nicht isolierten Enden der beiden Leiterbahnen (19, 20; 21, 22) am Platinenrand (23) gebildet ist.

2. Überspannungsschutzeinrichtung nach Anspruch 1, **dadurch gekennzeichnet, dass** die Schutzplatine (9) mit dem Steckelement (3) eine weitere Funkenstrecke bildet.

3. Überspannungsschutzeinrichtung nach Anspruch 2, **dadurch gekennzeichnet, dass** die Schutzplatine (9) eine elektrisch leitende Struktur (19, 22) aufweist, welche die weitere Funkenstrecke bildet.

4. Überspannungsschutzeinrichtung nach Anspruch 3, **dadurch gekennzeichnet, dass** die elektrisch leitende Struktur auf der Schutzplatine (9) in Form einer Leiterbahn ausgebildet ist, wobei eine lötstopplackfreie Zone (27, 28; 31) der Leiterbahn in der Umgebung einer, das Steckelement (5) aufnehmenden Öffnung (13) angeordnet ist.

5. Überspannungsschutzeinrichtung nach Anspruch 4, **dadurch gekennzeichnet, dass** die lötstopplackfreie Zone (31) in dem die Öffnung (13) umschließenden Lötauge (30) des Lötstopplacks (29) ausgebildet ist.

6. Überspannungsschutzeinrichtung nach Anspruch 3, **dadurch gekennzeichnet, dass** die elektrisch leitende Struktur als lötstopplackfreie Ausnehmung und/oder durchgehende Öffnung (27, 28) der Schutzplatine (9) ausgebildet ist.

7. Überspannungsschutzeinrichtung nach Anspruch 6, **dadurch gekennzeichnet, dass** die lötstopplackfreie Ausnehmung und/oder Öffnung (27, 28) in der Nähe des zu schützenden Steckerpins (5) angeordnet ist.

8. Überspannungsschutzeinrichtung nach Anspruch 1, **dadurch gekennzeichnet, dass** die Form der Leiterbahnen (19, 20, 21, 22) , welche zum Platinenrand (23) geführt sind, so gewählt sind, dass am Platinenrand (23) Leiterspitzen (34) entstehen.

9. Überspannungsschutzeinrichtung nach Anspruch 1 oder 8, **dadurch gekennzeichnet, dass** der Platinenrand (23) von mindestens einer durchgehenden Öffnung (14) der Schutzplatine (9) gebildet ist.

10. Überspannungsschutzeinrichtung nach Anspruch 1, **dadurch gekennzeichnet, dass** die Schutzplatine (9) eine Entstöreinrichtung (10; 15, 16) zur Verbesserung der elektromagnetischen Empfindlichkeit des elektronischen Gerätes (1) trägt.

11. Überspannungsschutzeinrichtung nach Anspruch 9, **dadurch gekennzeichnet, dass** die Entstöreinrichtung (10) ein Varistor ist.

12. Überspannungsschutzeinrichtung nach Anspruch 9, **dadurch gekennzeichnet, dass** die Entstöreinrichtung ein Kondensator (10) ist, der außerhalb des Gehäuses (1, 2) des elektronischen Gerätes (1) angeordnet ist und elektrisch einerseits mit dem Steckelement (5) der Steckeinrichtung (3) und andererseits mit dem Potential des elektrisch leitend ausgebildeten Gehäuses (1, 2) verbunden ist.

13. Überspannungsschutzeinrichtung nach Anspruch 12, **dadurch gekennzeichnet, dass** eine erste Kondensatorplatte (16) des Kondensators (10) in oder an der Steckeinrichtung (3) angeordnet ist.

14. Überspannungsschutzeinrichtung nach Anspruch 13, **dadurch gekennzeichnet, dass** die erste Kondensatorplatte (16) aus dem Steckelement (5) selbst ausgeformt ist.

15. Überspannungsschutzeinrichtung nach Anspruch 13, **dadurch gekennzeichnet, dass** die erste Kondensatorplatte (16) von einer, der auf der Schutzplatine (9) angeordneten und als Leiterfläche ausgebildeten Leiterbahnen (15) gebildet ist, welche neben dem Steckelement (5) angeordnet und mit diesem elektrisch verbunden ist und dass das elektrisch ausgebildete und mit Masse verbundene Gehäuse (1) des elektronischen Gerätes als zweite Kondensatorplatte dient.

16. Überspannungsschutzeinrichtung nach Anspruch 15, **dadurch gekennzeichnet, dass** die zweite, der auf der Schutzplatine (9) angeordneten und mit dem Gehäuse (1, 2) elektrisch verbundene Leiterfläche (18) mit dem Gehäuse (1, 2) eine zweite Kondensatorfläche bildet.

17. Überspannungsschutzeinrichtung nach Anspruch 16, **dadurch gekennzeichnet, dass** die elektrische Verbindung zwischen der zweiten Leiterfläche (15) der Schutzplatine (9) und dem Gehäuse (1, 2) durch mindestens ein, die Schutzplatine (9) und/oder die Steckeinrichtung (3) am Gehäuse (1,2) haltendes Befestigungsmittel (4) erfolgt.

18. Überspannungsschutzeinrichtung nach Anspruch 16, **dadurch gekennzeichnet, dass** eine Isolierung (17) zwischen der zweiten, auf der Oberfläche der Schutzplatine ausgebildeten Leiterfläche (18) und der Außenseite des Gehäuses (1,2) angeordnet ist.

19. Überspannungsschutzeinrichtung nach Anspruch 16, **dadurch gekennzeichnet, dass** die das Steckelement (5) umschließende Leiterfläche derart auf der Schutzplatine (9) angeordnet ist, dass sie auf der dem Gehäuse (1) zugewandten Seite der Steckeinrichtung (3) aufsetzbar und kontaktierbar ist.

20. Entstöreinrichtung nach Anspruch 1 oder 6, **dadurch gekennzeichnet, dass** für jedes Steckerelement (5) eine erste Kondensatorplatte vorgesehen ist, welche elektrisch gegeneinander isoliert sind.

## Claims

1. Overvoltage protection device for an electronic apparatus having a plug-in device which has at least one plug-in element (3) and is designed for mounting on a housing of the electronic apparatus, a protection board (9), which has a spark gap in order to dissipate overvoltages, being arranged on the plug-in element (3), **characterized in that** the protection board (9) has at least two conductor tracks (19, 20; 21, 22) which are located one above the other, are at different potentials and are routed to a board edge (23), with the thickness of an insulation layer (24, 25) arranged between the two conductor tracks (19, 20; 21, 22) being selected such that the spark gap is formed by the uninsulated ends of the two conductor tracks (19, 20; 21, 22) at the board edge (23).

2. Overvoltage protection device according to Claim 1, **characterized in that** the protection board (9) forms a further spark gap together with the plug-in element (3).

3. Overvoltage protection device according to Claim 2, **characterized in that** the protection board (9) has an electrically conductive structure (19, 22) which forms the further spark gap.

4. Overvoltage protection device according to Claim 3, **characterized in that** the electrically conductive structure is formed on the protection board (9) in the form of a conductor track, with a zone (27, 28; 31), which is free of solder resist, of the conductor track being arranged in the vicinity of an opening (13) which holds the plug-in element (5).

5. Overvoltage protection device according to Claim 4, **characterized in that** the zone (31) which is free of solder resist is formed in the solder land (30), which surrounds the opening (13), in the solder resist (29).

6. Overvoltage protection device according to Claim 3, **characterized in that** the electrically conductive structure is in the form of a recess, which is free of solder resist, and/or an opening (27, 28) through the protection board (9).

7. Overvoltage protection device according to Claim 6, **characterized in that** the recess and/or opening (27, 28), which is free of solder resist, is arranged in the vicinity of the plug pin (5) to be protected.

8. Overvoltage protection device according to Claim 1, **characterized in that** the shape of the conductor tracks (19, 20, 21, 22) which are routed to the board edge (23) is selected such that conductor tips (34) are produced at the board edge (23).

9. Overvoltage protection device according to Claim 1 or 8, **characterized in that** the board edge (23) is formed by at least one opening (14) through the protection board (9).

10. Overvoltage protection device according to Claim 1, **characterized in that** the protective board (9) is fit with a suppression device (10; 15, 16) to improve the electromagnetic sensitivity of the electronic apparatus (1).

11. Overvoltage protection device according to Claim 9, **characterized in that** the suppression device (10) is a varistor.

12. Overvoltage protection device according to Claim 9, **characterized in that** the suppression device is a capacitor (10), which is arranged outside the housing (1, 2) of the electronic apparatus (1) and is electrically connected firstly to the plug-in element (5) of the plug-in device (3), and secondly to the potential of the electrically conductive housing (1, 2).

13. Overvoltage protection device according to Claim 12, **characterized in that** a first capacitor plate (16) of the capacitor (10) is arranged in or on the plug-in device (3).

14. Overvoltage protection device according to Claim 13, **characterized in that** the first capacitor plate (16) is formed from the plug-in element (5) itself.

15. Overvoltage protection device according to Claim 13, **characterized in that** the first capacitor plate (16) is formed by one, of the conductor tracks (15) which are arranged on the protection board (9) and are in the form of conductor surfaces, which conductor track (15) is arranged alongside the plug-in element (5) and is electrically connected to it, and **in that** the electrically designed housing (1), which is connected to earth, of the electronic apparatus is used as the second capacitor plate.

16. Overvoltage protection device according to Claim 15, **characterized in that** the second conductor surface (18) which is arranged on the protection board (9) and is electrically connected to the housing (1, 2) forms a second capacitor surface with the housing (1, 2).

17. Overvoltage protection device according to Claim 16, **characterized in that** the electrical connection between the second conductor surface (15) of the protection board (9) and the housing (1, 2) is produced by at least one fastening means (4) which holds the protection board (9) and/or the plug-in device (3) on the housing (1, 2).

18. Overvoltage protection device according to Claim 16, **characterized in that** insulation (17) is arranged between the second conductor surface (18), which is formed on the surface of the protection board, and the outside of the housing (1, 2).

19. Overvoltage protection device according to Claim 16, **characterized in that** the conductor surface which surrounds the plug-in element (5) is arranged on the protection board (9) such that it can be placed and made contact with on the side of the plug-in device (3) facing the housing (1).

20. Interference-protection device according to Claim 1 or 6, **characterized in that** a first capacitor plate (16) is provided for each plug-in element (5), and these first capacitor plates (16) are electrically insulated from one another.

## Revendications

1. Dispositif limiteur de surtensions pour un appareil électronique équipé d'un dispositif enfichable comportant au moins un élément enfichable (3), conçu pour être fixé à un boîtier de l'appareil électronique, une platine de protection (9) étant disposée sur l'élément enfichable (3), laquelle comporte un éclateur pour la dérivation de surtensions, **caractérisé en ce que** la platine de protection (9) comporte au moins deux circuits conducteurs (19, 20 ; 21, 22) superposés conduisant un potentiel différent, lesquels sont conduits jusqu'à un bord d'une platine (23), l'épaisseur d'une couche isolante (24, 25) disposée entre les deux circuits conducteurs (19, 20 ; 21, 22) étant choisie de manière à ce que l'éclateur soit formé par les extrémités non isolées des deux circuits conducteurs (19, 20 ; 21, 22) au bord de la platine (23).

2. Dispositif limiteur de surtensions selon la revendication 1, **caractérisé en ce que** la platine de protection (9) constitue un éclateur supplémentaire avec l'élément enfichable (3).

3. Dispositif limiteur de surtensions selon la revendication 2, **caractérisé en ce que** la platine de protection (9) comporte une structure (19, 22) électroconductrice, qui forme ledit éclateur supplémentaire.

4. Dispositif limiteur de surtensions selon la revendication 3, **caractérisé en ce que** la structure électroconductrice est réalisée sur la platine de protection (9) sous forme d'un circuit conducteur, une zone exempte de vernis anti-soudure (27, 28 ; 31) du circuit conducteur étant disposée dans l'entourage d'une ouverture (13) recevant l'élément enfichable (5).

5. Dispositif limiteur de surtensions selon la revendication 4, **caractérisé en ce que** la zone exempte de vernis anti-soudure (31) est formée dans le dépôt conducteur annulaire (30) du vernis anti-soudure (29) entourant l'ouverture (13).

6. Dispositif limiteur de surtensions selon la revendication 3, **caractérisé en ce que** la structure électroconductrice est réalisée comme évidement exempt de vernis anti-soudure et/ou comme ouverture (27, 28) traversante de la platine de protection (9).

7. Dispositif limiteur de surtensions selon la revendication 6, **caractérisé en ce que** l'évidement exempt de vernis anti-soudure et/ou l'ouverture (27, 28) est disposé à proximité de la broche (5) à protéger.

8. Dispositif limiteur de surtensions selon la revendication 1, **caractérisé en ce que** la forme des circuits conducteurs (19, 20, 21, 22) qui sont conduits au bord de la platine (23), sont choisis de sorte à obtenir des pointes conductrices (34) au bord de la platine (23).

9. Dispositif limiteur de surtensions selon la revendication 1 ou 8, **caractérisé en ce que** le bord de la platine (23) est formé d'au moins une ouverture (14) traversante de la platine de protection (9).

10. Dispositif limiteur de surtensions selon la revendication 1, **caractérisé en ce que** la platine de protection (9) porte un dispositif de déparasitage (10 ; 15, 16) pour l'amélioration de la sensibilité électromagnétique de l'appareil électronique (1).

11. Dispositif limiteur de surtensions selon la revendication 9, **caractérisé en ce que** le dispositif de déparasitage (10) est un varistor.

12. Dispositif limiteur de surtensions selon la revendication 9, **caractérisé en ce que** le dispositif de déparasitage est un condensateur (10), disposé à l'extérieur du boîtier (1, 2) de l'appareil électronique (1) et qui est relié d'une part à l'élément enfichable (5) du dispositif enfichable (3) et d'autre part au potentiel du boîtier (1, 2) réalisé de manière électroconductrice.

13. Dispositif limiteur de surtensions selon la revendication 12, **caractérisé en ce qu'**une première plaque de condensateur (16) du condensateur (10) est disposée dans ou sur le dispositif enfichable (3).

14. Dispositif limiteur de surtensions selon la revendication 13, **caractérisé en ce que** la première plaque de condensateur (16) est moulée à partir de l'élément enfichable (5) lui-même.

15. Dispositif limiteur de surtensions selon la revendication 13, **caractérisé en ce que** la première plaque de condensateur (16) est formée par un des circuits conducteurs (15) disposés sur la platine de protection (9) et réalisé comme surface conductrice, disposée à côté de l'élément enfichable (5) et reliée électriquement à celui-ci, et **en ce que** le boîtier (1) électrique de l'appareil électronique et relié à la masse sert de deuxième plaque de condensateur.

16. Dispositif limiteur de surtensions selon la revendication 15, **caractérisé en ce que** la deuxième surface conductrice (18) disposée sur la platine de protection (9) et reliée électriquement au boîtier (1, 2) forme une deuxième surface de condensateur avec le boîtier (1, 2).

17. Dispositif limiteur de surtensions selon la revendication 16, **caractérisé en ce que** la liaison électrique entre la deuxième surface conductrice (15) de la platine de protection (9) et le boîtier (1, 2) est réalisée par au moins un moyen de fixation (4) maintenant la platine de protection (9) et/ou le dispositif enfichable (3) au boîtier (1, 2).

18. Dispositif limiteur de surtensions selon la revendication 16, **caractérisé en ce qu'**une isolation (17) est disposée entre la seconde surface conductrice (18) formée sur la surface de la platine de protection et la face extérieure du boîtier (1, 2).

19. Dispositif limiteur de surtensions selon la revendication 16, **caractérisé en ce que** la surface conductrice entourant l'élément enfichable (5) est disposée de telle sorte sur la platine de protection (9) qu'elle peut être déposée et mise en contact sur la seconde face du dispositif enfichable (3) tournée vers le boîtier (1).

20. Dispositif antiparasite selon la revendication 1 ou 6, **caractérisé en ce que** pour chaque élément enfichable (5) une première plaque de condensateur est prévue, qui sont isolées électriquement les unes contre les autres.
